**Europäisches Patentamt**

**European Patent Office**

**Office européen des brevets**

(19)

(11) Veröffentlichungsnummer: **0 254 072 B1**

(12) # EUROPÄISCHE PATENTSCHRIFT

(45) Veröffentlichungstag der Patentschrift: **17.04.91**

(51) Int. Cl.⁵: **H03H 11/20**

(21) Anmeldenummer: 87109219.3

(22) Anmeldetag: **26.06.87**

(54) **Schaltungsanordnung zum Verschieben der Phase eines Signals.**

(30) Priorität: **23.07.86 DE 3624854**

(43) Veröffentlichungstag der Anmeldung:
**27.01.88 Patentblatt 88/04**

(45) Bekanntmachung des Hinweises auf die
Patenterteilung:
**17.04.91 Patentblatt 91/16**

(84) Benannte Vertragsstaaten:
**AT BE CH DE ES FR GB GR IT LI LU NL SE**

(56) Entgegenhaltungen:
**US-A- 3 475 626**
**US-A- 4 051 519**
**US-A- 4 052 679**
**US-A- 4 297 641**

**ELECTRONIC ENGINEERING, Band 53, Nr.
658, Oktober 1981, Seite 31, London, GB; M.E.
SYMES: "A voltage controlled phase shifter"**

(73) Patentinhaber: **Deutsche Thomson-Brandt
GmbH**
**Hermann-Schwer-Strasse 3 Postfach 1307**
**W-7730 Villingen-Schwenningen(DE)**

(72) Erfinder: **Pery, Antoine**
**Mannheimerstrase 17**
**W-7730 Villingen-Schwenningen(DE)**

**Beschreibung**

Die Erfindung betrifft eine Schaltungsanordnung zum Verschieben der Phase eines Signals, nach dem Oberbegriff der Ausspruchs 1.

Derartige Schaltungsanordnungen, kurz Phasenschieber genannt, werden z.B. in Farbfernsehgeräten eingesetzt, um die Farbartsignale korrekt auszuwerten und den Farbton so zu regeln, daß eine möglichst natürliche Farbwiedergabe auf dem Bildschirm erzielt wird.

In der Druckschrift "RCA Solid State Circuits Application, Note ICAN-6472, USA, 5, 1983" ist ein integrierter Schaltkreis mit der Bezeichnung ICAN-6472 zur Demodulation des Farbartsignales beschrieben. Dieser integrierte Schaltkreis kann z.B. in Farbfernsehgeräten eingesetzt werden, um die Farbartsignale zu demodulieren.

Die Farbart setzt sich aus dem Farbton und der Farbsättigung zusammen. Bei dem Farbfernsehsystem NTSC wird der Farbton durch den Phasenwinkel des Farbartsignals bestimmt, während die Farbsättigung durch die Amplitude des Farbartsignals festgelegt ist.

Der integrierte Schaltkreis ICAN-6472 ist mit einem Farbtonregelkreis ausgestattet, um Verfälschungen des Farbtons infolge von unerwünschten, nicht kontrollierbaren Phasenverschiebungen des Farbartsignales, die an mehreren Stellen des Übertragungsweges auftreten können, zu vermeiden.

In Figur 9 auf Seite 5 der genannten Druckschrift ist der Farbartsignaldemodulator mit dem Farbtonregelkreis abgebildet. Das Farbartsignal, das an der Basis eines Transistors F2 liegt, gelangt ohne Phasenverschiebung über einen ersten Zweig, in dem ein Widerstand R6 liegt, an die Basis eines Transistors Q4. In einem zweiten Zweig, der zum ersten Zweig parallel liegt, wird die Phase des Farbartsignals durch ein phasenverschiebendes Netzwerk, einer Reihenschaltung aus einer Kapazität C1 und zwei Widerständen R3 und R5, um $+45°$ gedreht. Der Spannungsanteil des um $+45°$ phasenverschobenen Farbartsignals, der über dem Widerstand R3 abfällt, wird in einem Differenzverstärker, der aus zwei Transistoren Q2 und F3 gebildet wird, verstärkt und fällt anschließend am Widerstand R6 ab, an dem auch der nicht in der Phase verschobene und nicht verstärkte Spannungsanteil des Farbartsignales abfällt. Wegen des Differenzverstärkers aus den Transistoren Q2 und F3 beträgt die Phasenverschiebung des verstärkten Anteils des Farbartsignals $-135°$ gegenüber dem nicht phasenverschobenen Anteil des Farbartsignals. Die Amplitude und Phasenlage der am Widerstand R6 abfallenden und der Basis des Transistors Q4 zugeführten Spannung, der Summe aus dem phasenverschobenen verstärkten Anteil und aus dem nicht phasenverschoben Anteil des Farbartsignals, hängt von der Verstärkung des Differenzvestärkers aus den Transistoren Q2 und F3 ab, die mittels einer Steuerspannung veränderbar ist. Ist die Verstärkung null, so fällt am Widerstand R6 nur der nichtphasenverschobene Spannungsanteil des Farbart signals ab, während bei maximaler Verstärkung die Amplitude des Spannungsanteils des phasenverschobenen Farbartsignals etwa 1,4 mal größer ist als die des nichtphasenverschobenen Spannungsanteils des Farbartsignals. Die Phasenverschiebung der Spannung, die bei maximaler Verstärkung am Widerstand R6 abfällt und der Basis des Transistors Q4 zugeführt wird, beträgt $-90°$.

Ein wesentlicher Nachteil dieses bekannten Farbtonreglers ist darin zu sehen, daß sein Regelbereich nur $+45°$ beträgt und unsymmetrisch ist. Wegen der Unsymmetrie ist die Nullphasenlage nicht eindeutig definierbar und nur ungenau einstellbar.

Aus der US-A- 3 475 626 ist ein Phasenschieber zum Verschieben der Phase eines Signals bekannt, das über zwei parallele Zweige zu einem Summierer geleitet wird. In beiden Zweigen liegt je ein Multiplizierer. Im einen Zweig ist in Reihe zum Multiplizierer ein Phasenschieber vorgesehen, der die Phase des Signals um $90°$ verschiebt.

In der US-A- 4 051 519 ist ebenfalls ein Phasenschieber zum Verschieben der Phase eines Signals beschrieben, der zwei parallele Zweige aufweist. In jedem Zweig ist ein Differenzverstärker vorgesehen.

Auch in der US-A- 4 297 641 ist ein Phasenschieber mit zwei parallelen Zweigen zum Verschieben der Phase offenbart. Im einen Zweig liegt ein Verstärker, im anderen Zweig sind ein Verstärker und ein Phasenschieber vorgesehen. Die Signale am Ende der beiden parallelen Zweige werden in einem Vektoraddierer addiert.

In der US-A- 4 052 679 wird ein weiterer Phasenschieber zum Verschieben der Phase eines Signals erläutert. In zwei parallelen Zweigen ist je ein Differenzverstärker vorgesehen. Die Signale an den Ausgängen der beiden parallelen Zweigen werden in einem Transistor miteinander verknüpft.

Ferner wird auf Electronic Engineering, Vol. 53, October 1981, No. 685, London, England, verwiesen. Auf Seite 31 dieser Literaturstelle ist ein Phasenschieber zum Verschieben der Phase eines Signals beschrieben, das über zwei parallele Zweige geführt wird. In einem der beiden Zweige ist ein Phasenschieber vorgesehen. Die Signale am Ausgang der beiden parallelen Zweige werden addiert.

Alle angeführten Phasenschieber haben gemeinsam, daß in zwei parallelen Zweigen je ein Vektor gebildet wird. Diese beiden Vektoren bilden einen bestimmten Phasenwinkel zueinander. Eine Phasenverschiebung wird nun dadurch erzielt, daß die beiden Vektoren addiert werden. Durch Ändern des Betrages mindestens eines der beiden Vektoren läßt sich die Phasenverschiebung in gewissen Grenzen verändern.

Wie bereits erwähnt werden Phasenschieber zur Regelung des Farbtons in Farbfernsehgeräten eingesetzt. Um ei ne genaue Regelung des Farbtons zu erzielen, ist ein möglichst großer und zugleich symmetrischer Regelbereich des Phasenschiebers anzustreben.

Die in den einzelnen aufgezählten Literaturstellen angeführten Phasenschieber haben aber alle den Nachteil, daß die Nullphasenlage mit einfachen Mitteln nicht genau einstellbar ist.

Es ist daher Aufgabe der Erfindung, einen Phasenschieber so zu gestalten, daß ein möglichst weiter und zugleich symmetrischer Regelbereich erzielt wird und daß die Nullphasenlage mit einfachen Mitteln sehr genau einstellbar ist.

Die Erfindung löst diese Aufgabe für eine Schaltungsanorduung nach dem Oberbegriff des Anspruchs 1 dadurch, daß die eine Klemme des Eingangs der Schaltungsanorduung mit der Basis eines ersten Transistors und über einen ersten Widerstand mit der Basis eines zweiten Transistors verbunden ist, daß die andere Klemme des Eingangs mit der Basis eines dritten Transistors und über einen zweiten Widerstand mit der Basis eines vierten Transistors verbunden ist, daß die Basen des zweiten und vierten Transistors über eine Kapazität miteinander verbunden sind, daß der Emitter des zweiten Transistors über eine Reihenschaltung aus einem dritten und vierten Widerstand mit dem Emitter des vierten Transistors verbunden ist, daß der Emitter des dritten Transistors über eine Reihenschaltung aus einem fünften und sechsten Widerstand mit dem Emitter des ersten Transistors verbunden ist, daß der gemeinsame Verbindungspunkt des dritten und vierten Widerstandes mit dem Kollektor eines fünften Transistors verbunden ist, daß der Verbindungspunkt des fünften und sechsten Widerstandes mit dem Kollektor eines sechsten Transistors verbunden ist, daß die Basis des fünften Transistors mit der Basis des sechsten Transistors verbunden ist, daß der Emitter des fünften Transistors über einen siebten Widerstand und der Emitter 'des sechsten Transistors über einen achten Widerstand auf Bezugspotential liegen, daß der Kollektor des zweiten Transistors an die miteinander verbundenen Emitter eines siebten und achten Transistors angeschlossen ist, daß der Kollektor des vierten Transistors an die miteinander verbundenen Emitter eines neunten und zehnten Transistors angeschlossen ist, daß die Basis des siebten Transistors mit der Basis des zehnten Transistors und die Basis des achten Transistors mit der Basis des neunten Transistors verbunden ist, daß die Basis des siebten Transistors über eine Reihenschaltung aus einem neunten und zehnten Widerstand mit der Basis des achten Transistors verbunden ist, daß die miteinander verbundenen Kollektoren des ersten, achten und zehnten Transistors über einen elften Widerstand an einen Versorgungsspannung liegen, daß die miteinander verbundenen Kollektoren des dritten, siebten und neunten Transistors über einen zwölften Widerstand an der Versorgungsspannung liegen, daß der gemeinsame verbindungspunkt der Kollektoren des ersten, achten und zehnten Transistors die eine Klemme des Ausgangs bildet, daß die andere Klemme des Ausgangs vom gemeinsamen Verbindungspunkt der Kollektoren des dritten, siebten und neunten Transistors gebildet wird, daß den miteinander verbundenen Basen des fünften und sechsten Transistors eine erste Referenzspannung, dem gemeinsamen Verbindungspunkt des neunten und zehnten Widerstandes eine zweite Referenzspannung und den miteinander verbundenen Basen des achten und neunten Transistors eine Steuerspannung zugeführt werden.

Es zeigen

Figur 1 ein Prinzipschaltbild der Erfindung;
Figur 2 ein Zeigerdiagramm zur Erklärung des in Figur 1 gezeigten Prinzipschaltbildes;
Figur 3 ein weiteres Zeigerdiagramm;
Figur 4 den genauen Aufbau der erfindungsgemäßen Schaltungsanordnung nach Anspruch 1.

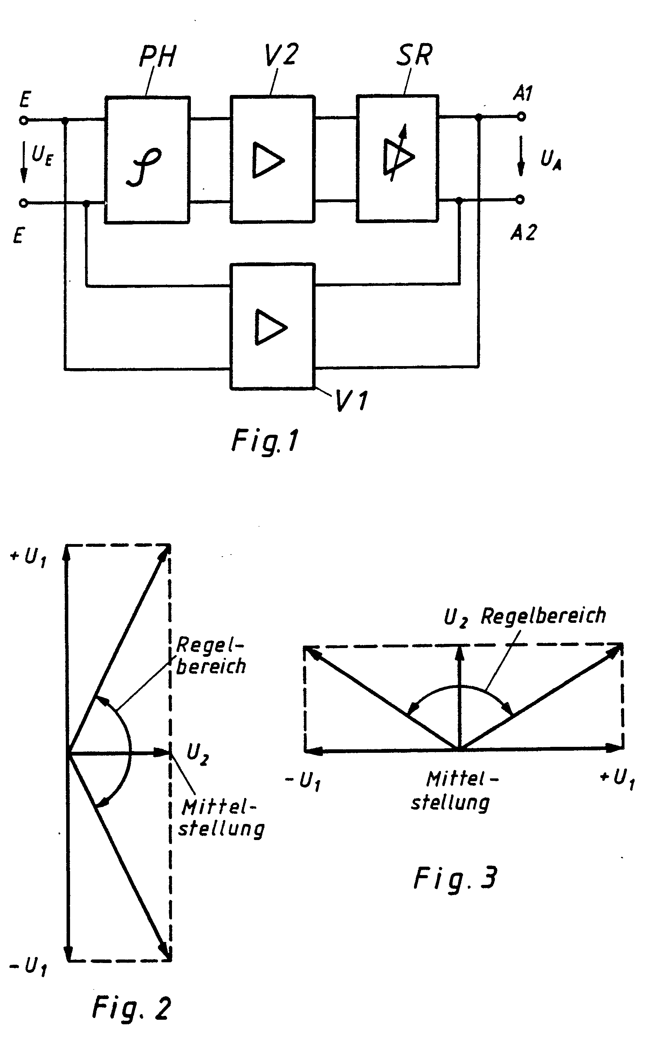

Anhand des in Figur 1 gezeigten Prinzipschaltbildes und des in Figur 2 dargestellten Zeigerdiagramms wird die Erfindung nun erläutert.

Am Eingang E des erfindungsgemäßen Phasenschiebers sind der Eingang eines phasendrehenden Netzwerkes PH und eines ersten Verstärkers V1 parallel geschaltet. Der Ausgang des phasendrehenden Netzwerkes PH ist mit dem Eingang eines zweiten Verstärkers V2 verbunden, dessen Ausgang mit dem Eingang eines Steuerbaren Verstärkers SR verbunden ist. Die parallel geschalteten Ausgänge des steuerbaren Verstärkers SR und des zweiten Verstärkers V2 bilden die Klemmen A1 und A2 des Ausgangs des Phasenschiebers. Der Signalweg teilt sich deshalb in zwei parallele Zweige auf.

Das Eingangssignal $U_E$, dessen Phase verschoben werden soll, wird am Eingang E in die beiden Zweige geleitet, indem es sowohl dem Eingang des ersten Verstärkers V1 als auch dem Eingang des phasendrehenden Netzwerkes PH zugeführt wird. Im einen Zweig wird es durch den ersten Verstärker V1 verstärkt. Im anderen Zweig wird dagegen die Phase des Eingangssignales $U_E$ zunächst um $+90°$ gedreht, ehe es im zweiten Verstärker V2 verstärkt wird. Mit dem auf den zweiten Verstärker V2 folgenden steuerbaren Verstärker SR sind die Amplitude und das Vorzeichen oder mit anderen Worten ausgedrückt die Polarität - des verstärkten und um $+90°$ phasenverschobenen Eingangssignals $U_E$ unabhängig voneinander steuerbar, so daß einerseits der Betrag des Signals am Ausgang des steuerbaren Verstärkers SR veränderbar ist und andererseits das Vorzeichen dieses Signals am Ausgang des steuerbaren Verstärkers $S_R$ entweder gleich oder entgegengesetzt als das Vorzeichen des Eingangssignals $U_E$ wählbar ist. An den beiden parallel geschalteten Ausgängen des steuerbaren Verstärkers SR und des ersten Verstärkers V1, den Klemmen A1 und A2 des Ausgangs des Phasenschiebers, überlagern sich deshalb zwei Signale: Das eine Signal ist ohne Phasenverschiebung verstärkt, während das andere Signal, dessen Betrag steuerbar und dessen Vorzeichen invertierbar ist, gegenüber dem Eingangssignal $U_E$ eine Phasenverschiebung von $+90°$ aufweist.

Wie das überlagerte Signal am Ausgang des Phasenschiebers aussieht, ist aus dem in Figur 2 dargestellten Zeigerdiagramm ersichtlich. Auf der Abszisse ist das Signal $U_2$ am Ausgang des ersten Verstärkers V1 dargestellt. Dazu um $+90°$ phasenverschoben liegt das Signal $U_1$ am Ausgang des steuerbaren Verstärkers SR auf der Ordinate, dessen Wert zwischen $+U_1$ und $-U_1$ durch den steuerbaren Verstärker SR steuerbar ist. Wenn z.B. die Verstärkung im zweiten Zweig doppelt so groß gewählt ist wie im ersten Zweig, so wird ein symmetrischer Regelbereich von etwa $±62°$ erzielt. Je nach der Verstärkung in den beiden Zweigen läßt sich der Regelbereich variieren. Je größer das Verhältnis aus der Verstärkung im zweiten Zweig zur Verstärkung im ersten Zweig gewählt ist, desto größer wird der Regelbereich. Beträgt das Verhältnis 1:1 so ergibt sich ein symmetrischer Regelbereich von $±45°$; ein Verhältnis größer 1 bewirkt einen symmetrischen Regelbereich von mehr als $±45°$.

Es ist auch möglich, den steuerbaren Verstärker SR im anderen Zweig nach dem ersten Verstärker V1 vorzusehen. Das zugehörige Zeigerdiagramm zeigt Figur 3.

Anstelle von Verstärkern mit konstanter Verstärkung können auch regelbare Verstärker vorgesehen sein (vgl. die eingangs genannten Dokumente).

Der in Figur 1 gezeigte Phasenschieber ist wegen seines in weiten Grenzen variierbaren symmetrischen Regelbereiches besonders gut als Farbtonregler in einem Farbfernsehgerät geeignet.

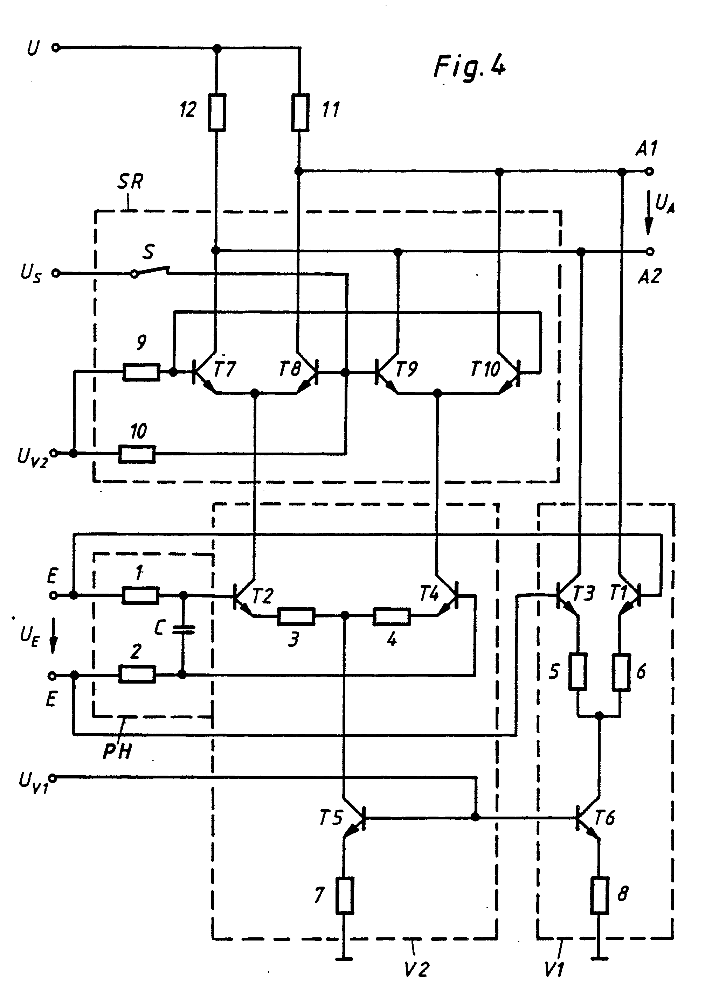

In Figur 4 ist gezeigt, wie der in Figur 1 dargestellte Phasenschieber im einzelnen aufgebaut ist.

Die eine Klemme des Eingangs E ist mit der Basis eines ersten Transistors T1 und über einen ersten Widerstand 1 mit der Basis eines zweiten Transistors T2 verbunden. Die andere Klemme des Eingangs E ist mit der Basis eines dritten Transistors T3 und über einen zweiten Widerstand 2 mit der Basis eines vierten Transistors T4 verbunden. Die Basis des zweiten Transistors T2 ist über eine Kapazität C mit der Basis des vierten Transistors T4 verbunden. Der Emitter des zweiten Transistors (T2) ist über eine Reihenschaltung aus einem dritten und vierten Widerstand (3, 4) mit dem Emitter des vierten Transistors (T4) verbunden. Der Emitter des dritten Transistors T3 ist über eine Reihenschaltung aus einem fünften und sechsten Widerstand 5 und 6 mit dem Emitter des ersten Transistors T1 verbunden.

Der gemeinsame Verbindungspunkt des dritten und vierten Widerstandes 3 und 4 ist mit dem Kollektor eines fünften Transistors T5 verbunden, während der Verbindungspunkt des fünften und sechsten Widerstandes 5 und 6 mit dem Kollektor eines sechsten Transistors T6 verbunden ist. Die Basis des fünften Transistors T5 ist mit der Basis des sechsten Transistors T6 verbunden. Der Emitter des fünften Transistors T5 liegt über einen siebten Widerstand 7 und der Emitter des sechsten Transistors T6 über einen achten Widerstand 8 auf Bezugspotential. Der Kollektor des zweiten Transistors T2 ist an die miteinander verbundenen Emitter eines siebten und achten Transistors T7 und T8 angeschlossen, während der Kollektor des vierten Transistors T4 an die miteinander verbundenen Emitter eines neunten und zehnten Transistors T9 und T10 angeschlossen ist. Die Basis des siebten Transistors T7 ist mit der Basis des zehnten Transistors T10 und die Basis des achten Transistors T8 ist mit der Basis des neunten Transistors T9 verbunden. Die Basis des siebten Transistors T7 ist über eine Reihenschaltung aus einem neunten und zehnten Widerstand 9 und 10 mit der Basis des achten Transistors T8 verbunden. Die miteinander verbundenen Kollektoren des ersten, achten und zehnten Transistors T1, T8 und T10 liegen über einen elften Widerstand 11 an einer Versorgungsspannung U, während die miteinander verbundenen Kollektoren des dritten, siebten und neunten Transistors T3, T7 und T9 über einen zwölften Widerstand 12 an der Versorgungsspannung U liegen. Der gemeinsame Verbindungspunkt der Kollektoren des ersten, achten und zehnten Transistors T1, T8 und T10 bildet die eine Klemme A1 des Ausgangs, während die andere Klemme A2 des Ausgangs vom gemeinsamen Verbindungspunkt der Kollektoren des dritten, siebten und neunten Transistors T3, T7 und T9 gebildet wird.

Das phasenverschiebende Netzwerk PH, das eine Phasenverschiebung von $+90°$ bewirkt, besteht aus den Widerständen 1 und 2 sowie aus der Kapazität C. Der auf das phasendrehende Netzwerk PH folgende Verstärker V2 ist, wie die Anordnung der Widerstände 3, 4, 7 und der Transistoren T2, T4, T5 zeigt, als Differenzverstärker mit hoher Gleichtaktunterdrückung ausgeführt. Ebenso ist der Verstärker V1 aus den Widerständen 5, 6, 8 und den Transistoren T1, T3, T6 als differenzverstärker mit hoher Gleichtaktunterdrückung aufgebaut. Der steuerbare verstärker SR, bestehend aus den Widerständen 9 und 10 sowie aus den Transistoren T7, T8, T9 und T10, ist symmetrisch aufgebaut. An den miteinander verbundenen Basen der Transistoren T5 und T6 liegt eine erste Referenzspannung $U_{V1}$.

Das Eingangssignal $U_E$ wird einerseits den Basen der Transistoren T1 und T3 des Differenzverstärkers V1 zugeführt, so daß es verstärkt aber ohne Phasenverschiebung an den Kollektoren der beiden Transistoren T1 und T3 abgreifbar ist. Andererseits wird das Eingangssignal $U_E$ über das phasenverschiebende Netzwerk PH den Basen der Transistoren T2 und T4 des Differenzverstärkers V2 zugeführt, so daß es verstärkt und mit einer Phasenverschiebung von $+90^\circ$ an den Kollektoren dieser beiden Transistoren T2 und T4 abgreifbar ist.

Über den Widerstand 9 wird den Basen der Transistoren T7 und T10 sowie über den gleich groß gewählten Widerstand 10 den Basen der Transistoren T8 und T9 eine zweite Referenznung $U_{V2}$ zugeführt. Weil die beiden Transistoren T2 und T4 des Differenzverstärkers V2 im Gegentakt arbeiten, liegen entweder nur die Emitter des Transistorpaares T7 und T8 oder nur des Transistorpaares T9 und T10 über den Widerstand 3 bzw. 4, den Transistor T5 und den Widerstand 7 auf Bezugspotential.

Zum leichteren Verständnis der Funktionsweise des steuerbaren Verstärkers SR wird zunächst der Fall betrachtet, daß der Transistor T4 leitet, dagegen der Transistor T2 sperrt.

Mittels einer Steuerspannung $U_s$, die über einen steuerbaren Schalter S an die miteinander verbundenen Basen der Transistoren T8 und T9 angelegt wird, lassen sich entweder die Transistoren T8 und T9 oder T7 und T10 aufsteuern, weil diese beiden Transistorpaare im Gegentakt arbeiten. Ist die Steuerspannung $U_s$ positiv gegenüber der Spannung an den Basen der Transistoren T7 und T10, so werden die Transistoren T9 und T8 aufgesteuert, während die Transistoren T10 und T7 sperren. Dadurch wird das Potential an der Klemme A2 des Ausgangs gegen Bezugspotential gezogen, während das Potential an der Klemme A1 trotz des aufgesteuerten Transistors T8 U beträgt, weil der Transistor T2 des Differenzverstärkers V2 sperrt. Je mehr der Transistor T9 aufgesteuert wird, desto stärker wird das Potential an der Klemme A2 des Ausgangs gegen Bezugspotential gezogen. Auf diese Weise wird der Betrag des Signals am Ausgang des steuerbaren Verstärkers SR durch Änderung der Steuerspannung $U_s$ verändert. Eine Umkehrung des Vorzeichens des Signals wird erzielt, wenn die Steuerspannung $U_s$ negativ gegenüber dem Potential an den Basen der Transistoren T7 und T10 wird, weil bei diesem Spannungsverhältnis im Gegensatz zum vorhergewählten die Transistoren T7 und T10 aufgesteuert werden, die Transistoren T8 und T9 dagegen aber sperren. Dadurch wird jetzt das Potential an der Klemme A1 gegen Bezugspotential gezogen, während das Potential an der Klemme A2 trotz des aufgesteuerten Transistors T7 U beträgt, weil der Transistor T2 des Differenzverstärkers V2 sperrt. Je mehr der Transistor T10 aufgesteuert wird, desto stärker wird das Potential an der Klemme A1 gegen Bezugspotential gezogen. Auf diese Weise wird der Betrag des Signals am Ausgang des steuerbaren Verstärkers SR durch Ändern der Steuerspannung $U_s$ verändert. Weil die Steuerspannung $U_s$ aber nun negativ gegenüber dem Potential an den Basen der Transistoren T7 und T10 ist, hat das Signal am Ausgang des steuerbaren Verstärkers SR das entgegengesetzte Vorzeichen als im zuvor beschriebenen Fall.

Wenn beim Differenzverstärker V2 der Transistor T2 leitet, der Transistor T4 dagegen sperrt, gelten die gleichen Überlegungen, denn ist die Steuerspannung $U_s$ positiv gegenüber der Spannung an den Basen der Transistoren T7 und T10, so werden die Transistoren T9 und T8 aufgesteuert, während die Transistoren T10 und T7 sperren. Dadurch wird das Potential an der Klemme A1 gegen Bezugspotential gezogen, während das Potential an der Klemme A2 trotz des aufgesteuerten Transistors T9 U beträgt, weil der Transistor T4 des Differenzverstärkers V2 sperrt. Je mehr der Transistor T8 aufgesteuert wird, desto stärker wird das Potential an der Klemme A1 gegen Bezugspotential gezogen. Auf diese Weise wird der Betrag des Signals am Ausgang des steuerbaren Verstärkers SR durch Ändern der Steuerspannung $U_s$ verändert. Eine Umkehrung des Vorzeichens des Signals wird erzielt, wenn die Steuerspannung $U_s$ negativ gegenüber dem Potential an den Basen der Transistoren T7 und T10 wird, weil bei diesem Spannungsverhältnis im Gegensatz zum vorhergewählten die Transistoren T10 und T7 aufgesteuert werden, die Transistoren T8 und T9 dagegen aber sperren. Dadurch wird jetzt das Potential an der Klemme A2 gegen Bezugspotential gezogen während das Potential an der Klemme A1 trotz des aufgesteuerten Transistors T10 U beträgt, weil der Transistor T4 des Differenzverstärkers V2 sperrt. Je mehr der Transistor T7 aufgesteuert wird, desto stärker wird das Potential an der Klemme A2 gegen Bezugspotential gezogen. Auf diese Weise wird der Betrag des Signals am Ausgang des steuerbaren Verstärkers SR durch Ändern der Steuerspannung $U_S$ verändert. Weil die Steuerspannung $U_S$ aber nun negativ gegenüber dem Potential an den Basen der Transistoren T7 und T10 ist, hat das Signal am Ausgang des steuerbaren Verstärkers SR das entgegengesetzte Vorzeichen als im zuvor beschriebenen Fall.

Ein besonderer Vorteil der Erfindung ist darin zu sehen, daß der Spannungszeiger in Figur 2 und 3 mit einfachen Mitteln' sehr genau in die Mittelstellung im Regelbereich gebracht werden kann. Hierzu wird der steuerbare Schalter S geöffnet. Weil bei geöffnetem steuerbarem Schalter S an den Basen der Transistoren T7, T8, T9 und T10 die Referenzspannung $U_{V2}$ liegt, kommt der Spannungszeiger genau in seine Mittelstellung zu liegen.

Der erfindungsgemäße Phasenschieber ist nicht nur für die Regelung des Farbtons bei dem Farbfernsehsystem NTSC geeignet, er kann z.B. auch vorteilhaft in einem PAL- oder SECAM-Decoder eingesetzt werden, um die Phase zwischen dem FBAS-Signal auf der direkten und dem FBAS-Signal auf der Verzögerungsleitung automatisch einzustellen.

## Ansprüche

1. Schaltungsanordnung zum Verschieben der Phase eines Signals ($U_E$), bei der das Signal ($U_E$) über zwei parallel geschaltete Zweige geleitet wird, bei der in einem der beiden Zweige ein phasenverschiebendes Netzwerk (PH) liegt und bei der in einem der beiden Zweige Mittel (SR) zur Steuerung der Amplitude und zur Invertierung des Vorzeichens des Signals ($U_E$) vorgesehen sind, **dadurch gekennzeichnet,** daß die eine Klemme des Eingangs (E) der Schaltungsanordnung mit der Basis eines ersten Transistors (T1) und über einen ersten Widerstand (1) mit der Basis eines zweiten Transistors (T2) verbunden ist, daß die andere Klemme des Eingangs (E) mit der Basis eines dritten Transistors (T3) und über einen zweiten Widerstand (2) mit der Basis eines vierten Transistors (T4) verbunden ist, daß die Basen des zweiten und vierten Transistors (T2, T4) über eine Kapazität (C) miteinander verbunden sind, daß der Emitter des zweiten Transistors (T2) über eine Reihenschaltung aus einem dritten und vierten Widerstand (3, 4) mit dem Emitter des vierten Transistors (T4) verbunden ist, daß der Emitter des dritten Transistors (T3) über eine Reihenschaltung aus einem fünften und sechsten Widerstand (5, 6) mit dem Emitter des ersten Transistors (T1) verbunden ist, daß der gemeinsame Verbindungspunkt des dritten und vierten Widerstandes (3, 4) mit dem Kollektor eines fünften Transistors (T5) verbunden ist, daß der Verbindungspunkt des fünften und sechsten Widerstandes (5, 6) mit dem Kollektor eines sechsten Transistors (T6) verbunden ist, daß die Basis des fünften Transistors (T5) mit der Basis des sechsten Transistors (T6) verbunden ist, daß der Emitter des fünften Transistors (T5) über einen siebten Widerstand (7) und der Emitter des sechsten Transistors (T6) über einen achten Widerstand (8) auf Bezugspotential liegen, daß der Kollektor des zweiten Transistors (T2) an die miteinander verbundenen Emitter eines siebten und achten Transistors (T7, T8) angeschlossen ist, daß der Kollektor des vierten Transistors (T4) an die miteinander verbundenen Emitter eines neunten und zehnten Transistors (T9, T10) angeschlossen ist, daß die Basis des siebten Transistors (T7) mit der Basis des zehnten Transistors (T10) und die Basis des achten Transistors (T8) mit der Basis des neunten Transistors (T9) verbunden ist, daß die Basis des siebten Transistors (T7) über eine Reihenschaltung aus einem neunten und zehnten Widerstand (9, 10) mit der Basis des achten Transistors (T8) verbunden ist, daß die miteinander verbundenen Kollektoren des ersten, achten und zehnten Transistors (T1, T8, T10) über einen elften Widerstand (11) an einer Versorgungsspannung (U) liegen, daß die miteinander verbundenen Kollektoren des dritten, siebten und neunten Transistors (T3, T7, T9) über einen zwölften Widerstand (12) an der Versorgungsspannung (U) liegen, daß der gemeinsame Verbindungspunkt der Kollektoren des ersten, achten und zehnten Transistors (T1, T8, T10) die eine Klemme (A1) des Ausgangs bildet, daß die andere Klemme (A2) des Ausgangs vom gemeinsamen Verbindungspunkt der Kollektoren des dritten, siebten und neunten Transistors (T3, T7, T9) gebildet wird, daß den miteinander verbundenen Basen des fünften und sechsten Transistors (T5, T6) eine erste Referenzspannung ($U_{V1}$), dem gemeinsamen Verbindungspunkt des neunten und zehnten Widerstandes (9, 10) eine zweite Referenzspannung ($U_{V2}$) und den miteinander verbundenen Basen des achten und neunten Transistors (T8, T9) eine Steuerspannung ($U_s$) zugeführt werden, wobei bei Fehlen der Steuerspannung (Us) die Phasen-Mittelstellung der Schaltungsanordnung eingestellt ist.

## Claims

1. A circuit arrangement for shifting the phase of a signal ($U_E$), in which the signal ($U_E$) is passed via two parallel-connected branches, in which in one of the two branches there lies a phase-shifting network (PH) and in which in one of the two branches means (SR) are provided for controlling the amplitude and for inverting the sign of the signal ($U_E$), **characterised in that** the one terminal of the input (E) of the circuit arrangement is connected to the base of a first transistor (T1) and via a first resistor (1) to the base of a second transistor (T2), that the other terminal of the input (E) is connected to the base of a third transistor (T3) and via a second resistor (2) to the base of a fourth transistor (T4), that the bases of the second and fourth transistors (T2, T4) are connected together via a capacitance (C), that the emitter of the second transistor (T2) is connected to the emitter of the fourth transistor (T4) via a series circuit comprising a third and fourth resistor (3,4), that the emitter of the third transistor (T3) is connected to the emitter of the first transistor (T1) via a series circuit comprising a fifth and sixth resistor (5,6), that the common connection point of the third and fourth resistor (3,4) is connected to the collector of a fifth transistor (T5), that the connection point of the fifth and sixth resistor (5,6) is connected to the collector of a sixth transistor (T6), that the base of the fifth transistor is connected to the base of the sixth transistor (T6), that the emitter of the fifth transistor (T5) is at reference potential via a seventh resistor (7) and the emitter of the sixth transistor (T6) is at reference potential via an eighth resistor (8), that the collector of the second transistor (T2) is connected to the connected emitters of a seventh and eighth transistor (T7, T8), that the collector of the fourth transistor (T4) is connected to the connected emitters of a ninth and tenth transistors (T9, T10), that the base of the seventh transistor (T7) is connected to the base of the tenth transistor (T10) and the base of the eighth transistor (T8) is connected to the base of the ninth transistor (T9), that the base of the seventh transistor (T7) is connected via a series circuit comprising a ninth and tenth resistor (9, 10) to the base of the eighth transistor (T8), that the connected collectors of the first, eighth and tenth transistors (T1, T8, T10) lie at a supply voltage (U) via an eleventh resistor (11), that the connected collectors of the third, seventh and ninth transistors (T3, T7, T9) lie at supply voltage (U) via a twelfth resistor (12), that the common connection point of the collectors of the first, eighth and tenth transistors (T1, T8, T10) forms the one terminal (A1) of the output, that the other terminal (A2) of the output is formed by the common connection point of the collectors of the third, seventh and ninth transistors (T3, T7, T9), that a first reference voltage ($U_{V1}$) is supplied to the connected bases of the fifth and sixth transistors (T5, T6), a second reference voltage ($U_{V2}$) is supplied to the common connection point of the ninth and tenth resistors (9,10) and a control voltage ($U_s$) is supplied to the connected bases of the eighth and ninth transistors (T8, T9), in which when there is no control voltage ($U_s$) the centre phase position of the circuit arrangement is set.

## Revendications

1. Montage pour décaler la phase d'un signal (UE), sur lequel le signal (UE) passe par deux branches montées en parallèle et qui comprend dans l'une des deux branches un circuit de déphasage (PH) et des moyens (SR) pour commander l'amplitude et l'inversion du signe du signal (UE), caractérisé en ce qu'une borne de l'entrée (E) du montage est reliée à la base d'un premier transistor (T1) et par une première résistance (1) à la base d'un deuxième transistor (T2), que l'autre borne de l'entrée (E) est reliée à la base d'un troisième transistor (T3) et par une deuxième résistance (2) à la base d'un quatrième transistor (T4), que les bases des deuxième et quatrième transistors (T2, T4) sont reliées ensemble par un condensateur C, que l'émetteur du deuxième transistor (T2) est relié à l'émetteur du quatrième transistor (T4) par un montage en série formé par une troisième et quatrième résistance (3, 4), que l'émetteur du troisième transistor (T3) est relié à l'émetteur du premier transistor (T1) par un montage en série formé par une cinquième et sixième résistance (5, 6), que le point de liaison commun des troisième et quatrième résistances (3, 4) est relié au collecteur d'un cinquième transistor (T5), que le point de liaison des cinquième et sixième résistances (5, 6) est relié au collecteur d'un sixième transistor (T6), que la base du cinquième transistor (T5) est reliée à la base du sixième transistor (T6), que l'émetteur du cinquième transistor (T5) et l'émetteur du sixième transistor (T6) sont reliés à un potentiel de référence respectivement par une septième resistance (7) et par une huitième resistance (8), que le collecteur du deuxième transistor (T2) est raccordé aux émetteurs reliés ensemble d'un septième et huitième transistor (T7, T8), que le collecteur du quatrième transistor (T4) est raccordé aux émetteurs reliés ensemble d'un neuvième et dixième transistor (T9, T10), que la base du septième transistor (T7) est reliée à la base du dixième transistor (T10) et la base du huitième transistor (T8) à la base du neuvième transistor (T9), que la base du septième transistor (T7) est reliée à la base du huitième transistor (T8) par un montage en série formé par une neuvième et dixième résistance (9, 10), que les collecteurs reliés ensemble des premier, huitième et dixième transistors (T1, T8, T10) sont raccordés à une tension d'alimentation (U) par une onzième résistance (11), que les collecteurs reliés ensemble des troisième, septième et neuvième transistors (T3, T7, T9) sont raccordes à la tension d'alimentation (U) par une douzième résistance (12), que le point de liaison commun des collecteurs des premier, huitième et dixième transistors (T1, T8, T10) constitue la borne (A1) de la sortie, que l'autre borne (A2) de la sortie est formée par le point de liaison commun des collecteurs des troisième, septième et neuvième transistors (T3, T7, T9), qu'une première tension de référence (UV1) est délivrée aux bases reliées ensemble des cinquième et sixième transistors (T5, T6), une deuxième tension de référence (UV2) est fournie au point de liaison commun des neuvième et dixième résistances (9, 10) et une tension de commande (Us) aux bases reliées ensemble des huitième et neuvième transistors (T8, T9), la phase du circuit étant en position médiane en cas d'absence de la tension de commande (Us).

**Fig.1**

**Fig. 2**

**Fig. 3**

Fig. 4